# EUROPEAN PATENT APPLICATION

(11) **EP 0 923 029 A1**
(43) Date of publication of application: **16.06.1999**
(21) Application number: 97121240.2
(22) Date of filing: 03.12.1997
(51) Int. Cl.: G06F 12/00, G06F 11/20

(54) **Redundant memory, data processor using same, and method therefor**

(71) Applicant: MOTOROLA, INC., Schaumburg, IL 60196 (US)
(72) Inventor: Toms, Thomas R., Round Rock, Texas, 78681 (US); Chrudimsky, David W., Round Rock, Texas, 78681 (US); Jew, Thomas, No. 1006 Austin, Texas, 78744 (US)
(74) Representative: Gibson, Sarah Jane

(57) **Abstract**

A redundant memory (25) includes a main memory (30), a multiplexer (32), a cache (40), and a non-volatile memory (31) for storing control, address, and data values used by cache (40) in a tag (41) and a data portion (42). The redundant memory (25) supports data replacement on a word-by-word basis without impacting access time of the redundant memory (25). Accesses of the failing address access a data portion (42) of the cache (40). The multiplexer (32) selects the cache (40) when the access address matches the programmed address in cache (40), which allows for a fully functional main memory (30). For example a failing flash electrically erasable programmable read only memory (FLASH EEPROM) data word may be replaced by programming the FLASH EEPROM address within a non-volatile memory (31). The redundant memory (25) may be integrated into a data processor such as a microcontroller (20) which also includes a central processing unit (21) and on-chip peripherals (24).

## Description

### Field of the Invention

This invention relates generally to semiconductor memories, and more particularly, to redundant memories and data processors integrating redundant memories.

### Background of the Invention

Semiconductor memories are used to store large amounts of data. These memories can store anywhere from several bits of information to several billion bits of information. As technology progresses, larger memories are integrated onto different types of data processing chips.

In computer systems several problems manifest themselves when memory locations produce incorrect data. An example of a problem is that of invalid or indeterminate functionality of a user's application due to the corruption of the control data being read from a faulty location stored in a data processor or integrated circuit. To understand the root of the problem involves the user in expensive analysis due to the randomness of these failures. Thus, it is necessary for memory components to be completely functional when used in computer systems.

An example of a semiconductor memory that stores large amounts of data in a small chip area is a random access memory (RAM). During the manufacturing process, an occasional random defect causes some of the memory cells to be nonfunctional, that is to be incapable of storing and providing correct information. However, it is wasteful to discard the entire chip after testing due to one or a small number of defective memory cells. The industry came up with a solution, redundant memories.

Redundant memories traditionally have to replace a whole row or column to fix a single bit in order to avoid discarding the whole chip. This is conventionally accomplished by using laser hardware to replace, by cutting and connecting, faulty bits with redundant rows or columns. Finding the exact physical location on the silicon wafer or die requires a program to calculate and store the location so that the laser machine can cut and mend the faulty locations with the redundant locations. This procedure requires purchasing the laser hardware and substantial test time, effectively increasing overhead.

Once the rows and/or columns have been cut and mended other problems become apparent: firstly, increased decode time by increasing column capacitance for row redundancy and increasing row capacitance for column redundancy; secondly, increased die size area which translates to an increase of end product cost.

The problem of increased decoding time is several fold. When implementing row or column redundancy, extra rows or columns must be decoded, which adds capacitance. One must also add in the time in selecting the redundant row or column and deselecting the row or column in the main array if a redundant row or column is selected by a decoder. Note that increasing capacitance increases delays and access time. The access time of a memory is measured from the time a valid input address is presented to the memory, to the time data being accessed is valid on the data bus.

A large variety of user memories, including dynamic random access memories (DRAMs), static random access memories (SRAM), read only memories (ROMs), electrically programmable ROMs (EPROMs), electrically erasable and programmable EPROMs (EEPROMs), and block erasable EEPROM (FLASH EEPROM) can use redundancy techniques to replace faulty rows and/or columns. If the memory is incorporated into a microcontroller, however, the memory may not be accessible in all modes of operation. In order to have these memories fully operational for a user application, a method was required to allow for customized configuration of non-volatile memory cells that provided the redundancy. This led to storing into non-volatile memory locations the start address of a faulty block, detected during testing of the memory such as the memory taught by U.S. Patent No. 5,179,536 entitled "SEMICONDUCTOR MEMORY DEVICE HAVING MEANS FOR REPLACING DEFECTIVE MEMORY CELLS".

An example of a row/column redundancy scheme requires an address buffer, a row decoder, a column decoder, a sense amplifier, and a memory cell array. An address buffer couples an input address to the row and column decoders that generate a row address signal and a column address signal. A comparator detects whether the input address matches a preset defective row/column. If a match occurs the select circuitry enables the redundant memory part to drive. If a match does not occur but the input address was within the range of the memory, a non-redundant row/column will be selected. Once the correct location is decoded, the sense amplifier will sense the data and drive the data onto the microcontroller's data bus. This type of redundant memory requires the address buffer to decode both the main memory as well as the redundant memory, which of course increases the time to decode an address.

What is needed, then, is a redundant memory technique which allows replacement of faulty portions within a memory array without specialized hardware, and which does not add significant integration circuit area or significantly slow decoding or sensing time. Such a memory and a data processor using it are provided by the present invention, whose features and advantages will be more clearly understood from the following detailed description taken in conjunction with the attached drawings.

### Brief Description of the Drawings

FIG. 1 illustrates in block diagram form a data processor in the form of a microcontroller having a redundant memory according to the present invention.
FIG. 2 illustrates in block diagram form a redundant memory which may be used as the redundant memory of FIG. 1.

### Detailed Description of a Preferred Embodiment

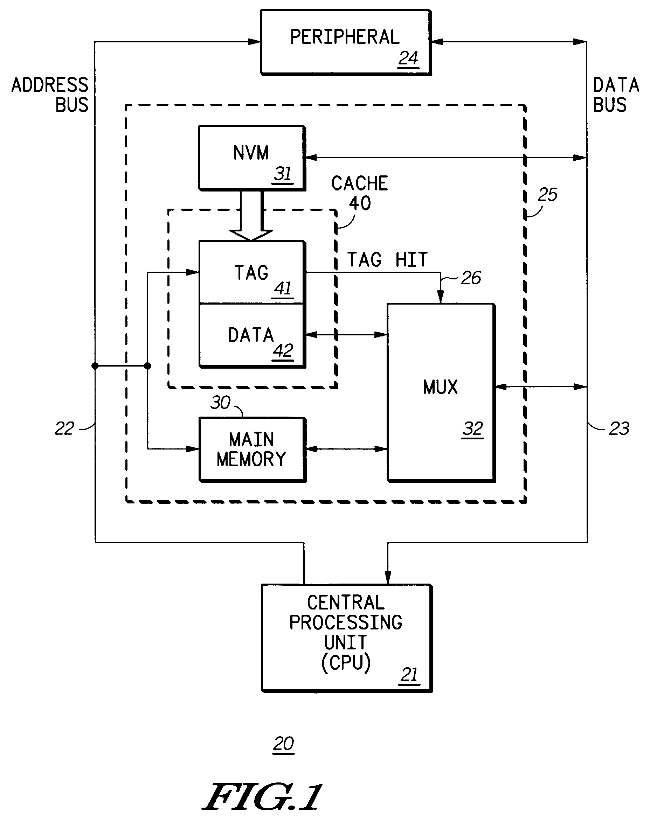

FIG. 1 illustrates in block diagram form a data processor in the form of a microcontroller 20 having a REDUNDANT MEMORY 25 according to the present invention. Microcontroller 20 is an integrated circuit microcontroller and generally includes a central processing unit (CPU) 21, an ADDRESS BUS 22, a DATA BUS 23, a PERIPHERAL 24, and REDUNDANT MEMORY 25. CPU 21 has an output terminal connected to ADDRESS BUS 22 and a bi-directional terminal connected to DATA BUS 23. PERIPHERAL 24 has an input terminal connected to ADDRESS BUS 22 and a bi-directional terminal connected to DATA BUS 23. REDUNDANT MEMORY 25 has an input terminal connected to ADDRESS BUS 22 and is bi-directionally connected to DATA BUS 23.

REDUNDANT MEMORY 25 includes a MAIN MEMORY 30, a NON-VOLATILE MEMORY 31, a multiplexer (MUX) 32, and a CACHE 40. MAIN MEMORY 30 has an input terminal connected to ADDRESS BUS 22 and a bi-directional terminal. NON-VOLATILE MEMORY 31 has a bi-directional terminal connected to DATA BUS 23, and an output terminal. MUX 32 has a first bi-directional terminal, a second bi-directional terminal connected to the bi-directional terminal of MAIN MEMORY 30, and a bi-directional terminal connected to DATA BUS 23. CACHE 40 includes a TAG portion 41, labeled "TAG", and a DATA portion 42, labeled "DATA". TAG portion 41 has an input terminal connected to ADDRESS BUS 22 and an output terminal for providing a control output signal labeled "TAG HIT" 26. DATA portion 42 is connected to TAG portion 41 and has a bi-directional terminal connected to the first bi-directional terminal of MUX 32.

MAIN MEMORY 30 is a conventional memory array with data elements organized into rows and columns. In response to an input address, a word line driver activates a word line which selects a given row. A separate portion of the address enables a column decoder to select a certain number of columns of memory cells located along the selected row, i.e. a particular data word. In MAIN MEMORY 30 each row is made up of multiple data words, which are made up of multiple memory cells, each of which are located at a row/column intersection.

According to the present invention, microcontroller 20 includes REDUNDANT MEMORY 25 to provide redundancy on a word-by-word basis without negatively affecting the access time of MAIN MEMORY 30. REDUNDANT MEMORY 25 includes MAIN MEMORY 30 as a main memory array. Information about defective memory locations of MAIN MEMORY 30 is provided by CACHE 40 in conjunction with NON-VOLATILE MEMORY 31. During testing, a defective memory word in MAIN MEMORY 30 is detected and NON-VOLATILE MEMORY 31 is programmed with a patch address corresponding to the defective memory word of MAIN MEMORY 30 by conventional very large scale integration (VLSI) programming techniques.

In operation, while microcontroller 20 is in reset the patch address or patch addresses of the defective word locations, detected in MAIN MEMORY 30 during test and programmed into NON-VOLATILE MEMORY 31, are transferred into TAG portion 41 of CACHE 40. Thereafter, during normal operation, MUX 32 selectively allows DATA BUS 23 to be connected to either MAIN MEMORY 30 or DATA portion 42 of CACHE 40 as determined by TAG HIT signal 26. Normal operation in the context of these discussions should be understood as points in time when microcontroller 20 is not in a reset state. Besides the transferring of the patch addresses stored in NON-VOLATILE MEMORY 31 to TAG portion 41 and DATA portion 42, the operation of a data processor during the reset state is well known in the art and will not be further discussed.

In normal operation, when REDUNDANT MEMORY 25 receives an address conducted on ADDRESS BUS 22, which is within a range associated with REDUNDANT MEMORY 25, CACHE 40 determines whether the patch address stored in TAG portion 41 matches the address conducted on ADDRESS BUS 22 while MAIN MEMORY 30 decodes a corresponding location. If the conducted address matches a patch address, TAG portion 41 activates output signal TAG HIT 26 to MUX 32 to select the first bi-directional terminal thereof to connect to DATA BUS 23. Simultaneously, the tag which hit in TAG portion 41 will select the appropriate data word in DATA portion 42, which will be connected to DATA BUS 23 through MUX 32. Note that the tag selection and connection to DATA BUS 23 is done independent of MAIN MEMORY 30 decoding circuitry and thus does not impact the access time thereof. If no tag location matches the address conducted on ADDRESS BUS 22, the access proceeds as normal in MAIN MEMORY 30 and output signal TAG HIT 26 from TAG portion 41 will be inactive causing MUX 32 to select the second bi-directional terminal, i.e. the terminal connected to the bi-directional terminal of MAIN MEMORY 30, to be connected to DATA BUS 23.

Upon connection to DATA BUS 23, any type of known access such as a read, write, program or erase can occur to either NON-VOLATILE MEMORY 31, DATA portion 42, or MAIN MEMORY 30.

In general, microcontroller 20 has each of the three main blocks of a classical computer system on a single integrated circuit chip including CPU 21, PERIPHERAL 24, and memory in the form of REDUNDANT MEMORY 25. CPU 21 may be any known or conventional CPU architecture including reduced instruction set computer (RISC), complex instruction set computer (CISC), digital signal processor (DSP) or any other known architecture. CPU 21 executes programmed instructions, which in the context of a microcontroller will typically be stored on-hip and may be stored within REDUNDANT MEMORY 25. PERIPHERAL 24 may be any conventional input/output module such as a serial or parallel input/output port, timer and the like. In addition, REDUNDANT MEMORY 25 may also store operating parameters or provide a data scratch pad area for CPU 21. Alternatively, microcontroller 20 may include a different class of memory besides REDUNDANT MEMORY 25. In such a case one of the two memories may be non-volatile memory in order to store program instructions and operating parameters, and the second memory may be a random access memory (RAM). Conjointly, microcontroller 20 may have several memory portions with defective memory cells that require redundancy for full functionality. The inventive REDUNDANT MEMORY 25 can be utilized even if each memory portion has a different class of memory for MAIN MEMORY 30. In this case, MAIN MEMORY 30 may also store operating parameters or provide a data scratch pad area for CPU 21 with redundancy, allowing a higher level of accuracy. This is to state that in the case where MAIN MEMORY 30 is not the memory in which the majority of opcode and operand data are stored, whether internal or external to microcontroller 20, REDUNDANT MEMORY 25 can still replace the function that portion of the memory previously had.

FIG 1. illustrates one possible microcontroller within a family of microcontrollers. Because microcontrollers in the same family of data processors generally have several different on-board peripherals, microcontroller 20 provides only one example of such a microcontroller. In other embodiments, microcontroller 20 may include several on-board peripherals such as a system integration module, a serial communications module, a timer module, or even other redundant memories, all of which may have corresponding integrated circuit pins. Furthermore, in the present embodiment CACHE 40 uses the address conducted on ADDRESS BUS 22 to determine a match, however, the address received need only be a portion of ADDRESS BUS 22. Furthermore, the address received could be a translated or encoded version of ADDRESS BUS 22 or a portion thereof if microcontroller 20 uses address translation or address encryption respectively. Finally, coprocessors may also be implemented in microcontroller 20.

Note that in the illustrated embodiment shown in FIG. 1, MAIN MEMORY 30 and NON-VOLATILE MEMORY 31 are made up of FLASH EEPROM cells. TAG portion 41 and DATA portion 42 are made up of static latches. However, in other embodiments MAIN MEMORY 30 may be made up of other types of memory cells including static random access memory (SRAM), dynamic random access memory (DRAM), non-volatile random access memory (NVRAM), programmable read only memory (PROM), erasable PROM (EPROM), electrically erasable PROM (EEPROM). In general, if MAIN MEMORY 30 is a non-volatile memory, NON-VOLATILE MEMORY 31 is preferably of the same type to allow sharing of control logic with MAIN MEMORY 30. However, it is only necessary that NON-VOLATILE MEMORY 31 be non-volatile memory, whether control logic is shared or not. If MAIN MEMORY 30 is ROM, it will be difficult for NON-VOLATILE MEMORY 31 to be ROM firstly because it is not known which ROM locations in MAIN MEMORY 30 are defective at manufacturing time, i.e. prior to testing time, and secondly because ROM is not programmable.

It should also be noted that in other embodiments, it may be preferable to combine the functionality of NON-VOLATILE MEMORY 31 and CACHE 40 of FIG. 1 into a single circuit. In this case, TAG portion 41 and DATA portion 42 could be any conventional non-volatile memory that would retain values even when REDUNDANT MEMORY 25 was powered down. In this case, configuration during reset could be bypassed. Finally, in other embodiments the function of MUX 32 need only be provided to connect DATA portion 42 or REDUNDANT MEMORY 50 to DATA BUS 23 depending on whether a tag hit was activated.

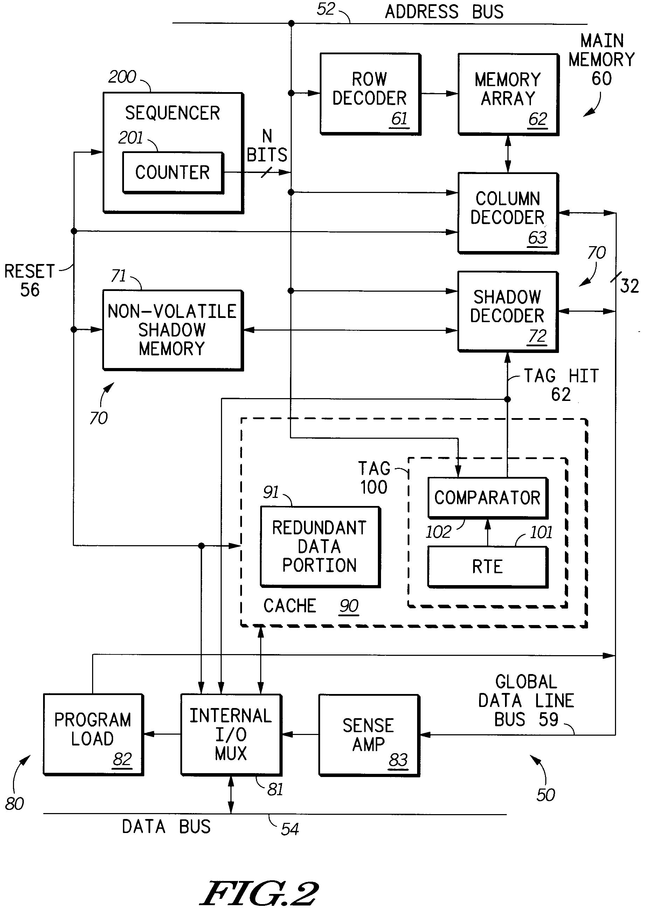

FIG. 2 illustrates in block diagram form a REDUNDANT MEMORY 50, illustrating a specific example of a redundant memory which may be used as REDUNDANT MEMORY 25 of FIG. 1. REDUNDANT MEMORY 50 has an input terminal connected to an ADDRESS BUS 52 and a bi-directional terminal connected to a DATA BUS 54. REDUNDANT MEMORY 50 also receives a reset input signal, labeled "RESET" 56. REDUNDANT MEMORY 50 includes generally a MAIN MEMORY portion 60, a shadow portion 70, an input/output portion 80, a CACHE 90, and a SEQUENCER 200.

MAIN MEMORY portion 60 includes a ROW DECODER 61, a MEMORY ARRAY 62 and a COLUMN DECODER 63. ROW DECODER 61 has an input terminal for receiving a portion of the signals conducted on the ADDRESS BUS 52, and an output terminal. MEMORY ARRAY 62 has an input terminal connected to the output terminal of ROW DECODER 61 and a bi-directional data terminal. COLUMN DECODER 63 has a first bi-directional terminal connected to a set of data lines, labeled "GLOBAL DATA LINE BUS" 59, a first input terminal for receiving control signal RESET 56, a second bi-directional terminal connected to the data terminal of MEMORY ARRAY 62, and a second input terminal for receiving a portion of the signals conducted on ADDRESS BUS 52.

Shadow portion 70 includes a NON-VOLATILE SHADOW MEMORY 71, and a SHADOW DECODER 72. NON-VOLATILE SHADOW MEMORY 71 has an input terminal for receiving RESET 56, and a bi-directional terminal. SHADOW DECODER 72 has a first input terminal for receiving a portion of the signals conducted on ADDRESS BUS 52, a second input terminal for receiving control signal TAG HIT 62, a first bi-directional terminal connected to GLOBAL DATA LINE BUS 59, and a second bi-directional terminal connected to the bi-directional terminal of NON-VOLATILE SHADOW MEMORY 71.

Input/output portion 80 provides a multiplexer function between the MAIN MEMORY 60 and CACHE 90 and includes an INTERNAL I/O MUX portion 81, a PROGRAM LOAD portion 82, and a SENSE AMPLIFIER (SENSE AMP) 83 . INTERNAL I/O MUX portion 81 has a first input terminal for receiving control signal RESET 56, a second input terminal for receiving control signal TAG HIT 62, a third input terminal, an output terminal, a first bi-directional terminal connected to DATA BUS 54, and a second bi-directional terminal. PROGRAM LOAD portion 82 has an input terminal connected to the output terminal of INTERNAL I/O MUX portion 81, and an output terminal connected to GLOBAL DATA LINE BUS 59. SENSE AMP 83 has an input terminal connected to GLOBAL DATA LINE BUS 59, and an output terminal connected to the third input terminal of the INTERNAL I/O MUX portion 81.

CACHE 90 has a first input terminal for receiving control signal RESET 56, a second input terminal for receiving a portion of the signals conducted on ADDRESS BUS 52, a bi-directional terminal connected to the second bi-directional terminal of INTERNAL I/O MUX portion 81 and an output terminal for providing output signal TAG HIT 62. CACHE 90 includes sub-portions labeled REDUNDANCY TAG ENABLE (RTE) 101, COMPARATOR 102, and REDUNDANT DATA PORTION 91. CACHE 90 may include multiple entries for storing redundant data. Illustrated in FIG. 2 is a representative entry which has RTE field 101, COMPARATOR field 102, and REDUNDANT DATA field 91. RTE field 101 has an output terminal for providing an output. COMPARATOR 102 has a first input terminal for receiving control from the output terminal of RTE field 101, a second input terminal for receiving a portion of the signals conducted on the ADDRESS BUS 52, and an output for providing signal TAG HIT 62. SENSE AMP 83 has an input terminal connected to the bus labeled GLOBAL DATA LINE BUS 59. Note that if redundancy is not required, the COMPARATOR 102 sections is kept in an inactive state effectively eliminating any power consumption by CACHE 90.

SEQUENCER 200 has an input terminal for receiving control signal RESET 56, a first output terminal for providing a predetermined number of bits, labeled N BITS, onto ADDRESS BUS 52, which is also connected internally to ROW DECODER block 61, COLUMN DECODER block 63, SHADOW DECODER 72, and CACHE 90. Within SEQUENCER 200 there is a COUNTER 201 for providing the N-BIT output while control signal RESET 56 is active. In addition, SEQUENCER 200 provides other control signals to various blocks within REDUNDANT MEMORY 50 that are not be discussed herein.

In operation, during the reset state, COUNTER 201 generates a sequence to cause control, address, and data information to be transferred from NON-VOLATILE SHADOW TAG AND DATA portion 71 and stored in RTE field 101, COMPARAT0R field 102, and REDUNDANT DATA field 91 respectively. Specifically a redundancy tag enable control bit is loaded into the RTE portion 101, the patch address of a defective memory word in MEMORY ARRAY 62 is loaded into COMPARATOR field 102. Data associated with the defective memory word may also be loaded into REDUNDANT DATA field 91 if MEMORY ARRAY 62 is a non-volatile memory. This information from NON-VOLATILE SHADOW MEMORY 71 through SHADOW DECODER 72 is provided onto GLOBAL DATA LINE BUS 59 to be translated by SENSE AMP 83 and coupled to the particular non-volatile memory cache fields via INTERNAL I/O MUX portion 81.

After the reset state, if RTE field 101 enables COMPARATOR 102, the address comparator output, signal TAG HIT 62, will be activated when the address conducted on ADDRESS BUS 52 matches the address field stored in COMPARATOR 102. REDUNDANT DATA field 91 will be accessed for any array operation in place of the defective array location in MEMORY ARRAY 62 when signal TAG HIT 62 is activated. Since the redundant data access occurs in parallel to MAIN MEMORY portion 60 access, the redundant data access does not increase access time.

During the programming and erasing sequences of REDUNDANT MEMORY 50, in the case that REDUNDANT MEMORY 50 is non-volatile memory, random control logic (RCL) activates programming voltages and control signals to appropriate sections within REDUNDANT MEMORY 50 by techniques well known in the art. The same RCL circuitry, not shown herein, used for programming MAIN MEMORY portion 60 during normal operation is used for programming and erasing NON-VOLATILE SHADOW MEMORY 71 during test mode.

CACHE 90 of FIG. 2 is a two-way associative cache having a total of four entries. However, it will be appreciated that CACHE 90 could be any other type of cache including a direct-mapped cache, a fully associative cache, or a cache associative by an arbitrary number.

Using existing complementary metal-oxide-semiconductor (CMOS) circuit design techniques, the majority of the area impact with the non-volatile memory tags (NVMTs) is in the random control logic (RCL) within SEQUENCER 200, not shown herein, where an increase of about 10 % per NVMT is noticed. The RCL is believed to account for about 8 % of the total 128 K-byte FLASH area. The area increase of a 128 K-byte FLASH EEPROM array is about 0.5 % per NVMT. In comparison, other known redundancy techniques require an area increase of about 4 % per row, 6 % per column, and 8 % per data structure when using a 128 K-byte FLASH EEPROM array.

Applied to these estimated percentages, one must consult standard integrated circuit manufacturing textbooks for defect density and yield information. Tradeoffs to select the optimal number of NVMTs to use should consider both design complexity that is incorporated into the random control logic, and the improvements to the system that the NVMT brings.

By now it should be appreciated that there has been provided a redundant memory that improves access time, reduces area, and reduces the number of unaffected cells which are replaced along with the defective memory cell compared to known techniques.

While the present invention has been described in the context of a preferred embodiment, those skilled in the art will recognize that modifications and variations can be made without departing from the spirit of the invention. For example, MAIN MEMORY 30 may be any type of memory such as SRAM, DRAM, ROM, PROM, EPROM, EEPROM, FLASH EEPROM, NVRAM, and the like. Also a microcontroller according to the present invention may use any known CPU architectures such as CISC, RISC, DSP, and the like along with redundant memory 25, and include a wide variety of peripherals as well. Therefore, it is intended that this invention encompass all such variations and modifications as fall within the scope of the appended claims.

## Claims

1. A redundant memory (25, 50) comprising:
a main memory (30, 60) having a plurality of rows and a plurality of columns, an address input, and a data terminal, wherein in response to an address received at said address input, said main memory (30, 60) selects a first memory cell wherein a first memory cell represents a portion of a selected row;
a cache (40, 90) having a tag portion (41, 100) for receiving and storing a patch address, and a redundant data portion (42, 91) for storing data corresponding to said patch address and coupled to a data terminal thereof; and
a multiplexer (32, 80) for coupling an external data bus (23, 54) to said data terminal of said cache (40, 90) when an input address matches said patch address of said cache (40, 90), and for coupling said first memory cell of said main memory (30, 60) to said external data bus (23, 54) when said input address is within a range of said main memory (30, 60).

2. The redundant memory (25, 50) according to claim 1 further comprising a non-volatile memory (31, 70) having a location for storing said patch address therein and an output coupled to said cache (40, 90).

3. The redundant memory (25, 50) according to claim 2 wherein said non-volatile memory (31, 70) is characterized as being programmable during normal operation of said redundant memory (25, 50).

4. The redundant memory (25, 50) according to claim 2 wherein said non-volatile memory (31, 70) is characterized as being programmable during a test mode.

5. The redundant memory (50) according to claim 1 wherein said cache (90) further comprises a redundancy tag enable field (RTE) (101) which selectively enables a comparison of said patch address to said input address in response to a logic state thereof.

6. The redundant memory (25, 50) according to claim 1 used in a data processor (20) comprising an address bus (22, 52), a data bus (23, 54), a central processing unit (21) for processing instructions and accessing data, coupled to said address bus (22, 52) and to said data bus (23, 54), wherein said redundant memory (25, 50) is coupled to said address bus (22, 52) and to said data bus (23, 54) of said data processor (20).

7. The redundant memory (25, 50) according to claim 6 wherein the data processor (20) is characterized as being a microcontroller and further comprises a peripheral (24) coupled to said address bus (22, 52) and said data bus (23, 54).

8. A method for providing redundancy for a main memory (30, 60) comprising the steps of:
detecting a defective memory cell in the main memory (30, 60);
storing a patch address corresponding to said defective memory cell into a tag portion (41, 100) of a cache (40, 90);
receiving an input address;
comparing said patch address to said input address;
coupling a data portion (42, 91) of said cache (40, 90) to a data bus (23, 54) if said patch address matches said input address; and
coupling a data terminal of the main memory (30, 60) to said data bus (23, 54) if said patch address does not match said input address when said input address is within a range of said main memory (30, 60).

9. A method for providing redundancy for a main memory (30, 60) comprising the steps of:
detecting a defective memory cell in the main memory (30, 60);
storing a patch address corresponding to said defective memory cell in a non-volatile memory (31, 70);
loading said patch address into a tag portion (41, 100) of a cache (40, 90);
receiving an input address;
comparing said patch address to said input address;
coupling a data portion (42, 91) of said cache (40, 90) to a data bus (23, 54) if said patch address matches said input address; and
coupling a data terminal of said main memory (30, 60) to said data bus (23, 54) if said patch address does not match said input address when said input address is within a range of said main memory (30, 60).

10. The method of claim 9 wherein said steps of detecting and storing comprise the steps of detecting and storing during a probe testing of the main memory (30, 60).
